# EUROPEAN PATENT APPLICATION

(11) **EP 1 052 061 A2**
(43) Date of publication of application: **15.11.2000**
(21) Application number: 00303716.5
(22) Date of filing: 03.05.2000
(51) Int. Cl.: B24B 37/04, B24B 49/14, H01L 21/306

(54) **System for chemical mechanical planarization**

(30) Priority: 03.05.1999 US 132174 P; 03.05.1999 US 132177 P; 12.05.1999 US 133884 P
(71) Applicant: Applied Materials, Inc., Santa Clara, California 95054 (US)
(72) Inventor: Tietz, James T., Fremont, CA 94536 (US); Li, Shijian, San José, CA 95129 (US); Birang, Manoocher, Los Gatos, CA 95033 (US); White, John M., Hayward, CA 94541 (US); Rosenberg, Lawrence M., San josé, CA 95120 (US); Scales, Martin, San José, CA 95125 (US); Emami, Ramin, San José, CA 95126 (US)
(74) Representative: Bayliss, Geoffrey Cyril

(57) **Abstract**

A semiconductor substrate processing system for polishing a substrate includes a platen (23) and a web (252) of polishing material disposed thereon. The system include a first fluid delivery arm (154) and a second fluid delivery arm (156) respectively adapted to dispose a first and a second polishing fluid on the polishing material. A sensor (226) produces a signal indicative of the temperature of the polishing process. An analyzer for determining a polishing metric from a polishing fluid disposed on the polishing material. A method for processing comprises the steps of sensing an indicia of a polishing metric, and regulating a rate of material removal. The step of regulating the rate of material removal may comprise steps such as changing the temperature of a fluid circulated and changing the chemistry of the polishing fluids. The step of sensing the indicia may include analyzing the effluent and sensing temperature.

## Description

The present invention relates generally to a processing system for polishing a substrate.

In semiconductor wafer processing, the use of chemical mechanical planarization, or CMP, has gained favor due to the enhanced ability to increase device density on a semiconductor workpiece, or substrate, such as a wafer. As the demand for planarization of layers formed on wafers in semiconductor fabrication increases, the requirement for greater system (*i.e*., process tool) throughput with less wafer damage and enhanced wafer planarization has also increased.

Two exemplary CMP systems that address these issues are described in U.S. Patent no. 5,804,507, issued September 8, 1998 to Perlov et al. and in U.S. Patent no. 5,738,574, issued April 15, 1998 to Tolles et al. Perlov et al. and Tolles et al. disclose a CMP system having a planarization system that is supplied wafers from cassettes located in an adjacent liquid filled bath. A transfer mechanism, or robot, facilitates the transfer of the wafers from the bath to a transfer station. The transfer station generally contains a load cup that positions wafers into one of four processing heads mounted to a carousel. The carousel moves each processing head sequentially over the load cup to receive a wafer. As the processing heads are loaded, the carousel moves the processing heads and wafers through the planarization stations for polishing. The wafers are planarized by moving the wafer relative to a polishing pad in the presence of a slurry or other polishing fluid medium. The polishing pad may include an abrasive surface. The slurry typically contains both chemicals and abrasives that aid in the removal of material from the wafer. After completion of the planarization process, the wafer is returned back through the transfer station to the proper cassette located in the bath.

Generally, slurries that contain abrasive particles have a number of undesirable aspects. For example, the abrasive particles entrained in the slurry may settle, thus changing the concentration of abrasive particles within the slurry. Additionally, the abrasives within the slurry wear and erode pumping mechanisms and related plumbing, requiring periodic maintenance and replacement while diminishing the service life of the system and components. Furthermore, slurry that dries on the tool surfaces is difficult to remove, and may become a source of unwanted particulate matter that may interfere with polishing operations or damage the surfaces of the wafer.

One solution eliminates the use of abrasive particles within the slurry by incorporating a plurality of fixed abrasive elements in the polishing pads. Generally, the fixed abrasive elements contain abrasive particles held in a binder that is disposed on a web of backing material. During a preconditioning operation, a portion of the binder is removed to expose some of the abrasive particles. The exposed abrasive particles supply the mechanical component of the polishing process. As the methodologies for preconditioning have not been fully developed, care must be taken not to remove excessive pad material. Examples of such fixed abrasive pads are described in United States Patent No. 5,692,950, by Rutherford et al. (issued December 2, 1997) and United States Patent No. 5,453,312, by Haas et al. (issued September 26, 1995). Typically, a polishing fluid (without abrasive particles) is used in concert with the fixed abrasive pad to provide the chemical component of the polishing process.

Fixed abrasive pads typically wear (*i.e*., are consumed during the polishing process) more slowly than conventional pads that are used with abrasive slurries. Typical fixed abrasive pads contain abrasive elements that are about 0.40 µm high. Due to the thin profile of the fixed abrasive pad, care must be taken during preconditioning so that the pad is not unnecessarily consumed. Once the fixed abrasive pad is conditioned and worn to a state wherein polishing uniformity may no longer be maintained, the pad must be replaced. To facilitate pad replacement, the polishing system is typically shut down during the maintenance period. The frequency of pad replacement directly correlates to diminished capacity of the polishing system. Thus, it would be desirable is the polishing system incorporated conditioning apparatus and process controls tat would minimize pad consumption.

Therefore, there is a need in the art for a system that minimizes the consumption of fixed abrasive pads in a chemical mechanical polishing system.

Generally, the present invention provides a system and method for planarizing a substrate. In one embodiment, the invention provides a polishing platen having at least a portion of polishing material disposed thereon, a first fluid delivery arm and a second fluid delivery arm. The first fluid delivery arm is adapted to dispose a first polishing fluid on the polishing material. The second fluid delivery arm is adapted to dispose a second polishing fluid on the polishing material.

In another embodiment, a substrate polishing apparatus comprises a polishing platen having at least a portion of polishing material disposed thereon on which the substrate undergoes the polishing process. A sensor produces a signal indicative of the temperature of the polishing process. Optionally, the signal is utilized to adjust a polishing metric, for example, by changing the temperature of heat transfer fluids disposed in the platen or a polishing head, changing the temperature of the polishing fluids, or adjusting the chemical components of the polishing fluids.

In another embodiment, an apparatus for substrate polishing comprises a web of polishing material having at least a first portion disposed on a polishing platen. An analyzer determines a polishing metric from a polishing fluid disposed on the polishing material.

In another aspect, a method for processing a workpiece is also disclosed. In one embodiment, the method comprises the steps of sensing an indicia of a polishing metric, and regulating a rate of material removal. In some embodiments, the step of regulating the rate of material removal may further comprise steps such as changing a temperature of a fluid circulated in a polishing head, changing the temperature of a fluid circulated in the platen and changing a chemistry of polishing fluids. The step of sensing the indicia may include analyzing an effluent and sensing a temperature.

The teachings of the present invention can be readily understood by considering the following detailed description in conjunction wit the accompanying drawings, in which:
Fig. 1 is a plan view of a chemical mechanical planarization system of the invention;
Fig. 2 is a sectional view of a polishing station taken along section line 2--2 of Fig. 1;
Fig. 3 is plan view of a polishing station;
Fig. 4 is partial sectional view of another embodiment of a polishing station;
Fig. 5 is another view of a polishing station depicting a bladder subpad; and
Fig. 6 is a partial view of a polishing station depicting a optical monitoring system.

To facilitate understanding, identical reference numerals have been used, where possible, to designate identical elements that are common to the figures.

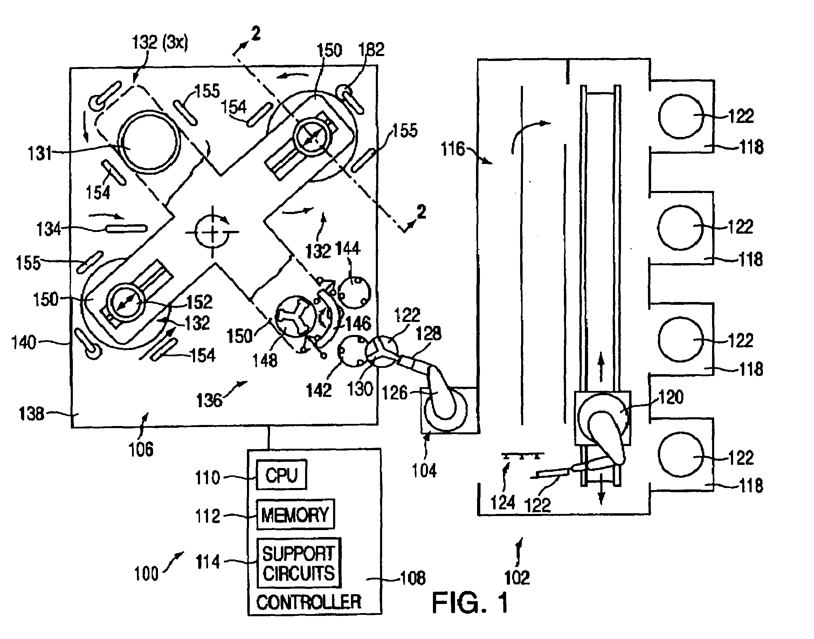

Fig. 1 depicts a plan view of a chemical mechanical planarization system 100. The exemplary system 100 generally comprises a factory interface 102, a loading robot 104, and a polishing module 106. Generally, the loading robot 104 is disposed proximate the factory interface 102 and the polishing module 106 to facilitate the transfer of substrates 122 therebetween.

A controller 108 is provided to facilitate control and integration of the modules comprising the system 100. The controller 108 comprises a central processing unit (CPU) 110, a memory 112, and support circuits 114. The controller 108 is coupled to the various components of the system 100 to facilitate control of, for example, the polishing, cleaning and transfer processes.

The factory interface 102 generally includes a cleaning module 116 and one or more wafer cassettes 118. An interface robot 120 is employed to transfer substrates 122 between the wafer cassettes 118, the cleaning module 116 and an input module 124. The input module 124 is positioned to facilitate transfer of substrates 122 between the polishing module 106 and the factory interface 102 by the loading robot 104. For example, unpolished substrates 122 retrieved from the cassettes 118 by the interface robot 120 may be transferred to the input module 124 where the substrates 122 may be accessed by the loading robot 104 while polished substrates 122 returning from the polishing module 106 may be placed in the input module 124 by the loading robot 104. Polished substrates 122 typically are passed from the input module 124 through the cleaning module 116 before the factory interface robot 120 returns the cleaned substrates 122 to the cassettes 118. An example of such a factory interface 102 that may be used to advantage is disclosed in United States Provisional Patent Application serial no. 60/139,222, filed June 15, 1999.

The loading robot 104 is generally positioned proximate the factory interface 102 and the polishing module 106 such that the range of motion provided by the robot 104 facilitates transfer of the substrates 122 therebetween. An example of a loading robot 104 is a 4-Link robot, manufactured by Kensington Laboratories, Inc., located in Richmond, California.

The exemplary loading robot 104 has an articulated arm 126 having a rotary actuator 128 at its distal end. An edge contact gripper 130 is coupled to the rotary actuator 128. The rotary actuator 128 permits the substrate 122 secured by the gripper 130 to be orientated in either a vertical or a horizontal orientation without contacting the feature side 120 of the substrate 122 and possibly causing scratching or damage to the exposed features. Additionally, the edge contact gripper 130 securely holds the substrate 122 during transfer, thus decreasing the probability that the substrate 122 will become disengaged. Optionally, other types of grippers, such as electrostatic grippers, vacuum grippers and mechanical clamps, may be substituted.

One polishing module 106 that can be used to advantage with the present invention is a REFLEXION™ Chemical Mechanical Polisher, manufactured by Applied Materials, Inc., located in Santa Clara, California. Other polishing modules 102 including those that use either polishing pads, polishing webs, or a combination thereof may also be used to advantage. Other systems that benefit include systems that move a substrate relative a polishing surface in a rotational, linearly or in other motion within a plane.

The exemplary polishing module 106 has a transfer station 136, a plurality of polishing stations 132 and a carousel 134 disposed on an upper or first side 138 of a machine base 140. In one embodiment, the transfer station 136 comprises at least an input buffer station 142, an output buffer station 144, a transfer robot 146, and a load cup assembly 148. The loading robot 104 places the substrate 122 onto the input buffer station 142. The transfer robot 146 has two gripper assemblies, each having pneumatic gripper fingers that grab the substrate 122 by the substrate's edge. The transfer robot 146 lifts the substrate 122 from the input buffer station 142 and rotates the gripper and substrate 122 to position the substrate 122 over the load cup assembly 148, then places the substrate 122 down onto the load cup assembly 148. An example of a transfer station that may be used to advantage is described by Tobin in United States Patent Application 09/314,771, filed October 6, 1999.

The carousel 134 is generally described by Tolles in the previously mentioned United States Patent No. 5,804,507. Generally, the carousel 134 is centrally disposed on the base 140. The carousel 134 typically includes a plurality of arms 150, each supporting a polishing head assembly 152. Two of the arms 150 depicted in Fig. 1 are shown in phantom such that a polishing surface 131 of one of the polishing stations 132 and the transfer station 136 may be seen. The carousel 134 is indexable such that the polishing head assemblies 152 may be moved between the polishing stations 132 and the transfer station 136.

Disposed adjacent each polishing station 132 is a conditioning device 190. The conditioning device 190 generally comprises a conditioning element 192 that may be actuated to come in contact with the polishing surface 131.

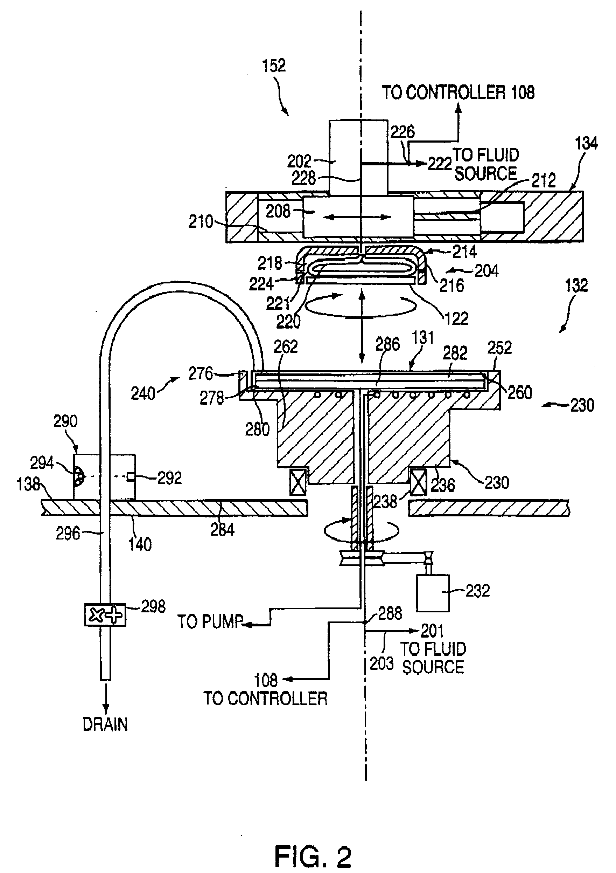

Fig. 2 depicts a sectional view of the polishing head 204 assembly 152 supported above the polishing station 132. The polishing head 204 assembly 152 generally comprises a drive system 202 coupled to a polishing head 204. The drive system 202 generally provides rotational motion to the polishing head 204. The polishing head 204 additionally may be actuated to extend towards the polishing station 132 such that the substrate 122 retained in the polishing head 204 may be disposed on the polishing surface 131.

The drive system 202 is coupled to a carrier 208 that translates upon a rail 210 disposed in the arm 150 of the carousel 134. A ball screw or other linear motion device 212 couples the carrier 208 to the carousel 134 and positions the drive system 202 and polishing head 204 along the rail 210.

In one embodiment, the polishing head 204 is a TITAN HEAD™ wafer carrier manufactured by Applied Materials, Inc., Santa Clara, California. Generally, the polishing head 204 comprises a housing 214 having an extending lip 216 that defines a center recess 218 in which is disposed a bladder 220. The bladder 220 may be comprised of an elastomeric material or thermoplastic elastomer such as ethylene propylene, silicone and HYTREL™. The bladder 220 is coupled to a fluid source 222 such that the bladder 220 may be controllably inflated or deflated. The bladder 220, when in contact with the substrate 122, retains the substrate 122 within the polishing head 204 by deflating, thus creating a vacuum between the substrate 122 and the bladder 220. A fluid source (not show) is typically disposed within the center recess 218 to wet the bladder 220. The fluid assists in retaining the substrate 122 to the bladder 220 by enhancing to seal between the substrate 122 and the bladder 220 when a vacuum is applied. Additionally, the fluid disposed between the bladder 220 and the substrate 122 provides surface tension that helps retain the substrate 122 to the bladder 220.

A retaining ring 224 circumscribes the polishing head 204 to retain the substrate 122 within the polishing head 204 while polishing. Optionally, polishing fluid may be dispensed between the bladder 220 and retaining ring 224 through a passage (not shown) coupling the polishing head 204 to a supply of polishing fluid.

To enhance heat transfer between the bladder 220 and substrate 122, the bladder 220 may be alternatively comprised of an elastomer having filler material that promotes conductive heat transfer such as carbon black or acetylene black. Acetylene black is available from Gulf Oil. Alternatively, the bladder 220 may include a resistive element 221 disposed (*i.e*., embedded) in the elastomeric material. The resistive element 221, typically a metallic foil, is coupled to a power source (not shown) that provides power to heat the bladder 220.

To further enhance heat transfer between substrate 122 and the bladder 220, the fluid within the bladder 220 may be circulated between the bladder 220 and the fluid source 222. The fluid source 222 provides temperature control of the fluid provided to the bladder 220. The fluid may be air, water, or other heat transfer fluid. A sensor 226 is disposed in the polishing head 204, bladder 220 or a fluid supply line 228 coupling the bladder 220 and fluid source 222 such that the fluid temperature, bladder temperature or other temperature indicative of the substrate 122 or polishing process temperature may be provided to the controller 108. The controller 108 thus determines whether the fluid temperature or flow rates through the bladder 220 requires adjustment to regulate the substrate 122 or process at a predetermined temperature. Alternatively, heat can be provided to accelerate or removed to slow the chemical component of the chemical mechanical polishing process over a portion of the polishing cycle.

Optionally, chemical agents may be dispensed between the bladder 220 and the retaining ring 224. Reservoirs (not show) in the retaining ring 224 dribble out chemical agents on the interior surface of the retaining ring 224. The supply of chemicals is dispensed at the optimum location, *i.e*., on the leading edge of the wafer. Advantageously, chemicals are not lost, distributed all over the platen or in undesirable places. Moreover, the chemicals are not evaporating before reaching the wafer.

The polishing station 132 generally comprises a platen 230 that is rotationally disposed on the base 140. The platen 230 is generally comprised of aluminum or other corrosion resistant material. The platen 230 has an upper portion 236 supported by a bearing 238 that is coupled to the base 140. The bearing 238 facilitates rotation of the platen 230 in relation to the base 140. Generally, the upper portion 236 has at least a portion of a polishing material 252 disposed thereon, defining the polishing surface 131.

The area inside the bearing 238 is open and provides a conduit for the electrical, mechanical, pneumatic, control signals and connections disposed between the platen 230 and base 140 to be run. Conventional bearings, rotary unions and slip rings (not shown) are provided such that electrical, mechanical, pneumatic, control signals and connections may be coupled between the base 140 and the rotating platen 230. The platen 230 is typically coupled to a motor 232 that provides the rotational motion.

The polishing material 252 may comprise a polishing pad or web having a smooth surface, a textured surface, a surface containing a fixed abrasive or a combination thereof. The polishing material 252 may be in the form of a roll or sheet of material that typically is releasably fixed, by adhesives, vacuum, mechanical clamps electrostatic force, screws and other holding devices to the platen 230. Optionally, the polishing material 252 may be advanced across the platen 230 during polishing.

In one embodiment, the upper portion 236 of the platen 230 is circular. The polishing material 252 is releasably disposed on the upper portion 236. The polishing material 252 may be held to the upper portion 236 of the platen 230 by vacuum drawn between the polishing material 252 and the platen 230.

The top surface 260 of the platen 230 contains a center recess 276 formed therein. A subpad 278 and a subplate 280 is disposed in the center recess 276. The subpad 278 is typically a plastic such as a foamed polyurethane having a durometer selected to produce a particular polishing result. The subpad 278 generally conforms to the plane of the substrate 122 held in the polishing head 204 and promotes global planarization of the substrate 122. The subplate 280 is positioned between the subpad 278 and the bottom of the recess 276 such that the upper surface of the subpad 278 is coplanar with the top surface 260 of the platen 230. Optionally, the subpad 278 and the subplate 280 may include aligning apertures formed therethrough to facilitate vacuum chucking of the polishing material 252.

To increase thermal transfer between the substrate 122 and the platen 230, the subpad 278 may be filled with a material that enhances conductive heat transfer through the subpad 278, for example carbon black or acetylene black. Additionally, the platen 230 may include one or more fluid channels 286 disposed below the recess 276 of the platen 230. The channels 286 are coupled by a fluid supply line 203 to a fluid source 201 that provides heat transfer fluid such as water. A sensor 288 is disposed in the platen 230, the subpad 278 or the fluid supply line 203 such that the fluid temperature or other temperature indicative of the substrate 122, polishing material 252 or polishing process temperature may be provided to the controller 108. The controller 108 thus determines whether the fluid temperature or flow rates through the channels 286 requires adjustment to regulate the substrate 122 or process at a predetermined temperature. Alternatively, heat can be provided by the fluid in the channels 286 to accelerate the chemical component of the chemical mechanical polishing process over a portion of the polishing cycle.

Generally, polishing pads with and without fixed abrasives may be utilized. Polishing pads without fixed abrasives are generally comprised of polyurethane and used with polishing fluids that include abrasives. Conventional pads (*i.e*., pads without fixed abrasives) are available from Rodel, Inc., of Newark, Delaware.

In one embodiment the polishing material 252 comprises a web of backing material having a plurality of polishing elements disposed thereon. The backing material is generally a flexible material, such as mylar. Each polishing element comprises a plurality of abrasive particles entrained in a binder. As the binder is removed by a conditioning device or during the polishing process, abrasive particles become exposed, providing the mechanical component of the polishing process. An example of such a polishing web is described in the previously mentioned patents United States Patent No.5,692,950, by Rutherford et al. and United States Patent No. 5,453,312, by Haas et al.

When the polishing surface 131 is comprised of a fixed abrasive polishing material, the conditioning element 192 is generally selected from a material that is harder than the binder but softer than the abrasive particles (typically comprised of ceria). Materials other than those present in the abrasive itself can be used, e.g., SiC or diamond, which are harder than ceria to condition the ceria. In another embodiment, a material softer than the abrasive particles but harder than the polymer matrix of the web is employed to selectively condition the polymer and not the abrasive particles. Different embodiments include a block either of monolithic silicon carbide, monolithic hard material, monolithic soft material or composite material.

The conditioning element 192 can be treated to condition its surface in an optimal way for conditioning the web surface, i.e., dressing the dressing pad. This can be done by either using photoresist and a photolithographic process by etching a pattern into the surface of the dressing material, machining or sand blasting. Additional aspects include conditioning at elevated temperatures; conditioning only the fresh part of the pad, i.e., preconditioning; or crushing the pad between rollers to loosen up the matrix to break some of the chemical bonds in the matrix so that it wears differently than it would otherwise. The conditioning element 192 may be in the shape of a disk, rod or roller. The conditioning element 192 may be brought in contact with the polishing surface 131 before processing (*e.g*., preconditioning) or between polishing wafers to remove "dishing" of the polishing surface 131.

Optionally, the polishing surface 131 may be conditioned by employing ultrasonic excitement, such as megasonics which involves ultrasonic motion in a liquid medium. Ultrasonics near the polishing surface 131 creates microcavitation which is a very violent process, thereby generating very microscopic, very high energy processes, damaging or roughening up the surface 131. Ultrasonics on web materials to provide pre-conditioning, either before use or on the platen as it goes round and round, when it's not under the wafer.

Another aspect comprises the selective removal of the polymeric binder, as by heat and/or solvent, which would affect the binder more than the abrasives, to obtain a higher wear rate of the binder and expose more of the abrasives. Or a laser may to top off the posts at an even height to condition. This can be done during the process as well as by preconditioning of the web, so when the wafer is not on that part of the web it can be polished.

Returning to Fig. 1, adjacent to each polishing station is disposed a first delivery tube 154 and a second delivery tube 155. Each delivery tube 154, 155 is disposed adjacent a respective polishing station 132. The first delivery tube 154 generally includes at least on supply tube (not shown) that delivers a polishing fluid to a plurality of nozzles 156 positioned along the first delivery tube 154. Alternatively, the plurality of nozzles 156 may be replaced by a single nozzle. The each of the nozzles 156 may be adapted to deliver the polishing fluid, the cleaning fluid, or both the polishing and cleaning fluids. Optionally, a single polishing delivery tube may by utilized.

Generally, the polishing fluids provide the chemical component (*i.e*., the chemical activity) of the polishing process. Abrasives, either in the polishing fluid or on the fixed abrasive pad provides the mechanical component of the polishing process. The polishing fluid may comprise a slurry or a liquid, and include chemical polishing agent, de-ionized water or a combination thereof. Additionally, abrasive particles may optionally be included in the polishing fluid. Generally, the polishing fluid contains chemical agents such as oxidizers, complexing agents, inhibitors, solublizers, buffers, de-ionized water or combinations thereof. The cleaning fluid typically comprises de-ionized water although other fluids may be used.

Similarly, the second delivery tube 155 generally includes at least on supply tube (not shown) that delivers a polishing fluid to a plurality of nozzles 157 positioned along the second delivery tube 155. Alternatively, the plurality of nozzles 157 may be replaced by a single nozzle. The each of the nozzles 157 may be adapted to deliver the polishing fluid, the cleaning fluid, or both the polishing and cleaning fluids.

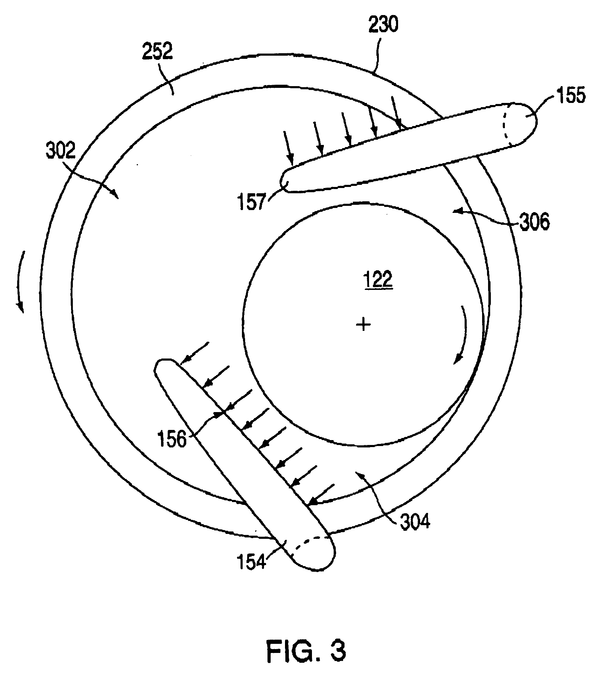

Referring to Fig. 3, the substrate 122 is disposed on a polishing portion 302 of the polishing material 252 during polishing. As the platen 230 rotates, an upstream portion 304 of polishing material 252 is defined as the area of the polishing material 252 that is about to move under the substrate 122 (*i.e*., become directly beneath the substrate 122 during the next increment of time). Similarly, a down stream portion 306 of polishing material 252 is defined as the area of the polishing material 252 that has just moved out from under the substrate 122 (*i.e*., was directly under the substrate 122 during the last increment of time). The first delivery tube 154 is disposed in a position where the nozzles 156 may deliver polishing fluid to the upstream portion 304 of the polishing material 252 as it rotates. The second delivery tube 155 is disposed in a position where the nozzles 157 may deliver polishing fluid to the downstream portion 306 of the polishing material 252 as it rotates. One skilled in the art will readily recognize that the designation of upstream and down stream is relative to the motion between the polishing media and substrate. Other types of polishing systems may incorporate the application of polishing fluid to a downstream and upstream side of the polishing process, including, for example, polishing systems having an x/y motion, or a linear motion such as a moving belt of polishing media. An example of a single delivery tube that may be modified to be used to advantage is disclosed in United States Patent Application Serial No. 09/244,456 (filed February 4, 1999) by Birang et al., and in United States Patent Application Serial No. 09/512,745 (filed February 24, 2000) by Shijian Li et al.

In one embodiment, the first delivery tube 154 delivers a first polishing fluid that comprises an oxidizer to the upstream portion 304 of the polishing surface 131. Alternatively, the first polishing fluid disposed by the first delivery tube 154 may further deliver inhibitors and buffers. The second delivery tube 155 delivers a second polishing fluid that comprises a solublizing agent to the downstream portion 306 of the polishing surface 131. Alternatively, the second polishing fluid disposed by the second delivery tube 155 may further comprise cleaning fluid (*e.g*., de-ionized water) and oxidizers.

For example, when polishing copper using a fixed abrasive pad, the first polishing fluid generally includes an oxidizer that forms CuO on the surface of the copper. Additionally, the first polishing fluid includes an inhibitor, such as BTA, provided to bond with the CuO to form a compound that remains relatively stable on the surface of the copper. The second polishing fluid generally includes a solublizing agent, such as NH₃, bonds with the CuO to form Cu(NH₄)ₓ, where x is 1-6. As Cu(NH₄)ₓ, is relatively soluble, this compound readily moves from the surface of the copper and into solution. Since the inhibitor and solublizing agent compete for sites on the CuO surface, the rate of chemical removal of copper from the surface may be controller by controlling the ratio of the inhibitors to solublizing agents. The mechanical polishing component provided by the abrasive articles of the polishing material. Generally, since the CuO is harder than the abrasive articles, the pad only removes CuO that has reacted with the inhibitors or the complexing agents to form other compounds. By introducing the oxidizers and inhibitors to the upstream portion and introducing the solublizing agents down stream, the chemical portion of the chemical mechanical polishing process may be enhanced by quickly removing abraded material (*i.e*., polishing byproducts) and controlling the relative concentrations of the first polishing fluid and the second polishing fluid in the reaction zone (*i.e*., between the substrate and polishing portion of the polishing surface). By efficiently polishing the substrate, more substrates may be polished per linear feet of polishing material (*i.e*., the polishing material will be consumed at a slower rate relative the number of substrates polished).

In an alternative embodiment, the polishing fluid includes at least one of tartaric acid, glycine or EDTA. In another embodiment, tartaric acid, glycine or a combination thereof is disposed on the upstream portion 304 of the polishing material 252 to oxidize a copper layer on the substrate 122. Optionally, EDTA may be disposed on the downstream portion 306 of the polishing material 252.

After each substrate is polishing, the polishing material is cleaned by supplying a cleaning fluid to the polishing material through one or both of the delivery tubes 154 and 155. Generally, a pressure of at least about 200 psi of cleaning fluid is disposed by the delivery tube 154, delivery tube 155 or delivery tubes 154 and 155, upon the polishing material between each polishing operation (*i.e*., between the polishing of each substrate 122). The cleaning fluid removes the any debris, abraded material, loose material or other contamination from between the abrasive elements or from the upper surface of the polishing material.

To enhance the control of the rate of the chemical reaction between the polishing fluid and the substrate, the temperature of the polishing fluid may be controlled. For example, one of the sensors (226, 288 and 604) may provide the controller 108 with an indicia of the reaction temperature at or near the polishing surface. The controller 108 may adjust the temperature of the polishing fluid to regulate (*i.e*., accelerate or slow) the chemical component of the chemical mechanical polishing process over a portion of the polishing cycle.

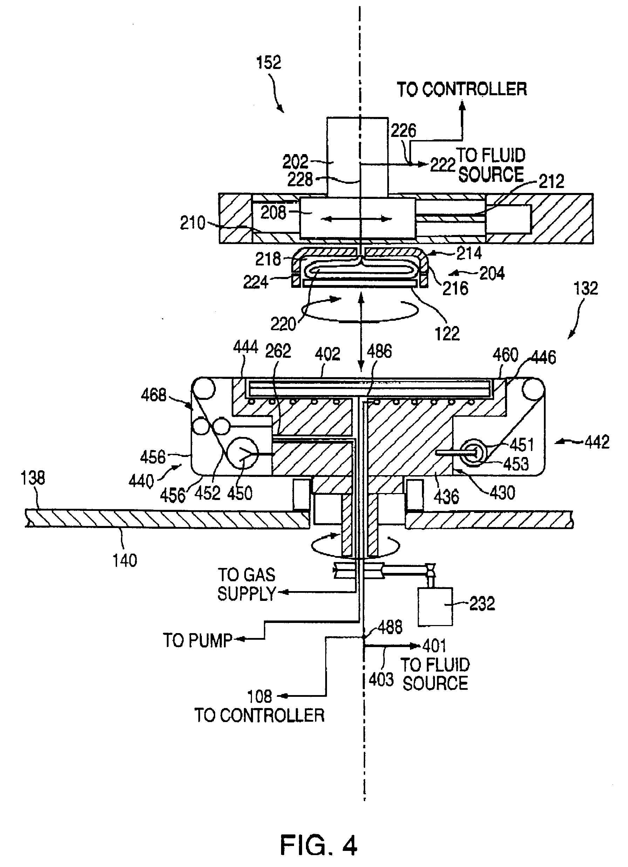

Fig. 4 depicts another embodiment of a platen 430. The platen 430 includes a rectangular upper portion 436 having opposing short sides 444, 446. An unwind station 440 and a take-up station 442 are disposed on the short side 444 and the short side 446, respectively. A web 402 of polishing material 452 is disposed across a top surface 460 of the upper portion 436 of the platen 430 between the unwind station 440 and the take-up station 442. Generally, the unused portion of the polishing material 452 is stored on the unwind reel 450 prior to processing.

A portion of the polishing material 452 is indexed across the upper portion 436 of the platen 430 utilizing a web indexing means 468, typically between polishing cycles (*i.e*., after each substrate is polished). The indexing means 468 pulls an adjustable, predetermined length (*i.e*., between about 0.05 to about 1.0 inches) of unused polishing material 452 off the unwind reel 450 as needed to maintain uniformity of the polishing process as the polishing material is consumed or worn during the polishing process. A tensioning device 453, coupled to a take-up reel 451 in the take-up station 442 rolls a corresponding length of used polishing material 452 on the take-up reel 451, thus maintaining the tension of the web 402 between the unwind station 440 and the take-up station 442. An example of such a polishing station and polishing platen is described in the United States Patent Application 60/132,177. Alternatively, the polishing material 252 may be incrementally or continually advanced during polishing.

To increase thermal transfer between the substrate 122 and the web 402 disposed on the platen 430, a subpad 478 underlying the web 402 may be filled with a material that enhances conductive heat transfer through the subpad 478, for example carbon black or acetylene black. Additionally, the platen 430 may include one or more fluid channels 486 disposed below subpad 478 of the platen 430. The channels 486 are coupled by a fluid supply line 403 to a fluid source 401 that provides heat transfer fluid such as water. A sensor 488 is disposed in the platen 430, the subpad 478 or a fluid supply line 403 such that the fluid temperature or other temperature indicative of the substrate 122, polishing material 452 or polishing process temperature may be provided to the controller 108. The controller 108 thus determines whether the fluid temperature or flow rates through the channels 486 requires adjustment to regulate the substrate 122 or process at a predetermined temperature. Alternatively, heat can be provided to accelerate the chemical component of the chemical mechanical polishing process over a portion of the polishing cycle.

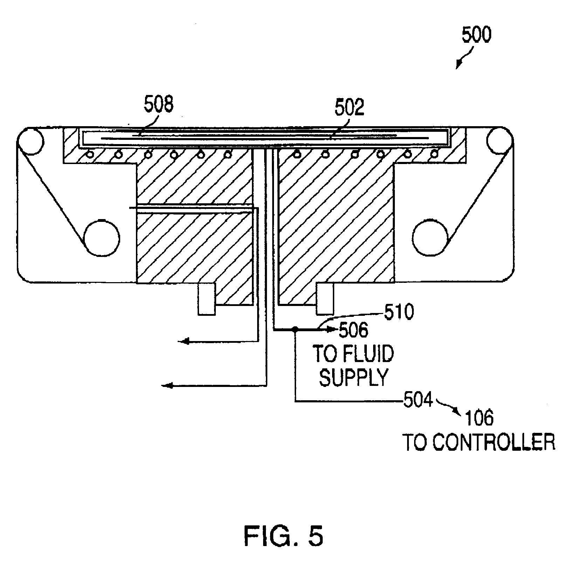

Fig. 5 depicts an alternate embodiment of a polishing station 500. The polishing station 500 is configured similarly to the platen 430 described with reference to Fig. 4, except the polishing pad and subplate are replaced by a subpad bladder 502. The subpad bladder 502 is coupled to a fluid supply 506. A sensor 504 is coupled to the subpad bladder 502 or a supply line 710 coupling the subpad bladder 502 and supply 506. The sensor 504 provides an indicia of bladder pressure to the controller 108. The pressure of the subpad bladder 502 may be regulated to control the stiffness of the subpad bladder 502 and conformity of the polishing surface. Generally, the subpad bladder 502 is fabricated from an elastomeric or thermoplastic elastomer such as ethylene propylene, silicone and HYTREL™. Optionally, the subpad bladder 502 may be fabricated from an elastomer containing material that enhances the heat transfer between the subpad bladder 502 and the substrate 122. Such materials include carbon black and acetylene black. The fluid pressurizing the subpad bladder 502 may be circulated and have the fluid temperature controlled to regulate the temperature of the substrate 122 and the polishing process. To effectively regulate the temperature, the sensor 504 (or another sensor similarly positioned) provides the controller 108 with an indicia of the fluid temperature. Alternatively, the bladder 502 may include a resistive element 508 incased in an elastomeric material. The resistive element 508, generally a metallic foil, is coupled to a power source (not shown) that provides power to heat the bladder 502.

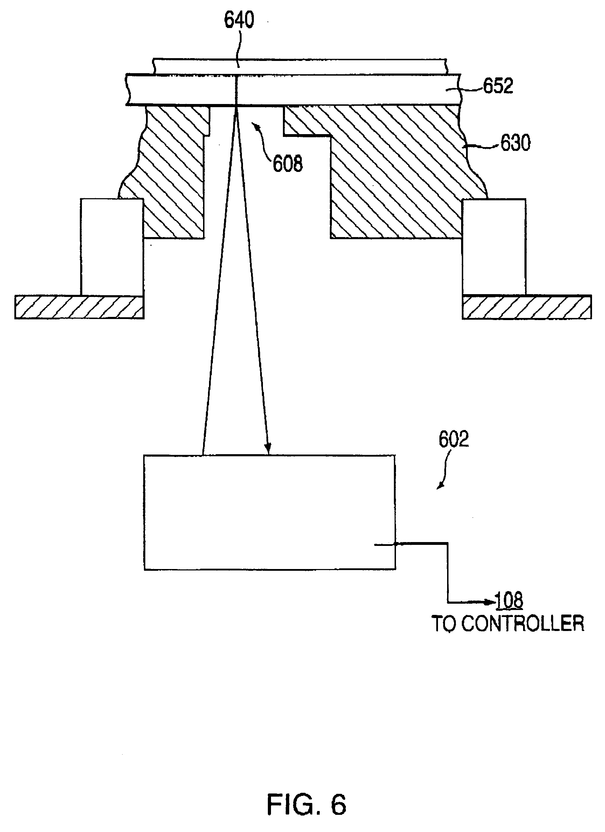

Fig. 6 depicts a portion of the polishing material 652 disposed on a platen 630 that includes an optical monitoring system 602 that is coupled to the controller 108. The monitoring system 602 is basically a laser that shines up at a substrate 640 through the polishing material 652 and then reflects back down again. As the film on the substrate gets thicker and thinner, the reflective intensity changes in a characteristic way to enable accurate measurement of the film thickness during polishing by providing sensors. The present invention provides a sealed window 608 in the platen 630. An optical monitoring system that may be used to advantage is described in United States Patent Application Serial No. 08/689,930 (filed August 16, 1996), by Birang et al.

Returning to Fig. 2, a metric of the polishing process, such as the polishing rate, may be monitored with an analyzer 290 that is coupled to the controller 108. Generally, the analyzer 290 comprises a spectroscope that analyzes the composition of the effluent polishing fluid by passing a beam of light from a light source 292 through the polishing fluid to a detector 294. Typically, the effluent is analyzed to determine the amount of abraded material (*i.e*., material removed from the substrate 122 by either chemical or mechanical means) present in the effluent. Alternatively, the analyzer 290 may comprise a particle measuring device. The particle measuring device determines the number and size of the particles passing between the light source 292 and detector 294. Particle detectors are available from Particle Measuring Systems. Inc., Boulder, Colorado. Optionally, particles may be detected by analyzing the conductivity, viscosity, magnetics, refractivity, and the color, (*e.g*., spectroscopic absorption).

For example, the amount of copper in the effluent (*i.e*., the copper abraded from the substrate 122) may be monitored by spectrographic detection using the analyzer 290. Large amounts of copper may indicate that the polishing rate is too high. The process may be changed, for example by altering the ratio of inhibitors and solublizing agents, or by transferring heat to or from the polishing area, thus altering the rate of material removal from the substrate. Additionally, adjusting the chemistry in response to the polishing rate may minimize the amount of polishing fluid consumed during polishing, thus reducing the operating cost of the system 100. Alternatively, the polishing rate may be changed (*i.e*., adjusted) by varying the other process parameters, including those discussed above.

The analyzer 190 may be mounted remotely from the polishing surface 131 and receive the effluent via a tube 296. Typically, the effluent is drawn through the tube 296 by a vacuum or peristaltic pump 298. Alternatively, the analyzer 190 may be mounted on the carousel 134. When mounted on the carousel 190, the light source 292 may reflect the light beam off the polishing surface 131 to the detector 194, passing through the effluent disposed on the polishing surface 131.

Referring to Figs. 1 and 2, in operation, the substrate 122 is retrieved from one of the cassettes 118 by the interface robot 120. The interface robot 120 transfers the substrate 122 to the input module 124 where it is retrieved by the loading robot 104. The loading robot 104 transfers the substrate 122 to the transfer station 136 where the substrate 122 is loaded into one of the polishing heads 204.

The carousel 134 positions the substrate 122 over one of the polishing stations 132. The drive system actuates to place the substrate 122 in contact with the polishing material. Both the polishing head and the polishing material rotate, while the drive system is oscillated along the arm 150 of the carousel 134, thus providing the polishing motion of the substrate 122 relative the polishing material 252.

During polishing, the various sensors provide the controller 108 with process information. For example, the sensors 226, 288 and 604 provide the controller 108 with information regarding the temperature of the polishing process or substrate 122. Using the temperature information, the temperature of the fluids used in the bladder 220, the bladder 602 and the channels 286 may be regulated to cause a change in the polishing process. For example, the fluid in the bladder 220 may be heated to increase the chemical activity between the polishing fluids and the substrate 122, thus increasing the polishing rate. Conversely, the polishing rate may be reduced in the opposite manner.

Additionally, the analyzer 290 may monitor the amount of removed material present in the effluent during polishing. The controller 108 may use the signal from the analyzer 290 to adjust the polishing rate. The polishing rate may also be adjusted by changing the ratio of chemicals used during polishing (*i.e*., increase the ratio of cleting agents to inhibitors) to induce a faster polishing rate. Conversely, the polishing rate may be reduced in the opposite manner. With the polishing rate optimized, the amount of polishing material consumed per polished substrate is minimized, thus extending the service interval of the polishing system 100 and reducing the cost of consumables.

Once polishing is completed, the substrate 122 is removed from the polishing material and indexed to another polishing station or returned to the transfer station. Polished substrates 122 are retrieved from the transfer station by the loading robot 104 and transferred to the factory interface module 102 where the substrate 122 is cleaned and ultimately returned to one of the storage cassettes 118.

Although the teachings of the present invention that have been shown and described in detail herein, those skilled in the art can readily devise other varied embodiments that still incorporate the teachings and do not depart from the spirit of the invention.

## Claims

1. Apparatus for semiconductor substrate polishing comprising:
a polishing platen;
a polishing material having at least a first portion disposed on the polishing platen, the polishing material having an upstream portion and a downstream portion;
a first polishing fluid delivery tube adapted to disposed a first polishing fluid on the upstream portion of the polishing material; and
a second polishing fluid delivery tube adapted to disposed a second polishing fluid on the downstream portion of the polishing material.

2. The apparatus of claim 1, wherein the first polishing fluid is comprised of one or more materials selected from the group of BTA, oxidizers, inhibitors, de-ionized water and buffers.

3. The apparatus of claim 1, wherein the second polishing fluid comprised of one or more materials selected from the group of solublizers, de-ionized water and ammonia.

4. The apparatus of claim 1, wherein the first polishing fluid is temperature controlled.

5. The apparatus of claim 1 wherein the polishing material moves relative the polishing platen.

6. The apparatus of claim 1 wherein the polishing material further comprises a fixed abrasive.

7. A semiconductor substrate polishing system comprising:
a polishing platen;
at least one polishing head disposed above the polishing platen;
a polishing material having at least a first portion disposed on the polishing platen;
a first polishing fluid delivery arm adapted to disposed a first polishing fluid on the platen; and
a second polishing fluid delivery arm adapted to disposed a second polishing fluid on the platen.

8. Apparatus for semiconductor substrate polishing comprising:
a polishing platen;
a polishing material having at least a portion disposed on the polishing platen on which the substrate undergoes the polishing process; and
a sensor that produces a signal indicative of the temperature of the polishing process.

9. The apparatus of claim 9, wherein the sensor is disposed in the platen.

10. The apparatus of claim 9, wherein the platen further comprises fluid channels adapted to flow heat transfer fluid.

11. The apparatus of claim 9, wherein the platen further comprises:
a subpad disposed between the polishing material and the platen, the subpad having a filler that enhances heat transfer.

12. The apparatus of claim 9, wherein the filler is carbon black, acetylene black, or a resistive element.

13. The apparatus of claim 9, wherein the platen further comprises a bladder.

14. The apparatus of claim 13, wherein the pressure within the bladder is regulated

15. The apparatus of claim 13, wherein the bladder is adapted to receive a temperature controlled fluid.

16. The apparatus of claim 15, wherein the temperature control fluid temperature is regulated in response to the signal generated by the sensor.

17. The apparatus of claim 9 further comprising a polishing head coupled to the sensor.

18. The apparatus of claim 17, wherein the polishing head further comprises:
a bladder adapted to flow heat transfer fluid.

19. The apparatus of claim 17, wherein the polishing head further comprises a bladder having a filler that enhances heat transfer.

20. The apparatus of claim 19, wherein the filler is carbon black, acetylene black, or a resistive element.

21. The apparatus of claim 17, wherein the polishing head further comprises:
a retaining ring;
and a bladder, wherein a polishing fluid is disposed therebetween.

22. Apparatus for semiconductor substrate polishing comprising:
a polishing platen;
a polishing material having at least a first portion disposed on the polishing platen;
a polishing fluid disposed on the portion of polishing material; and
an analyzer for determining a polishing metric form the polishing fluid.

23. The apparatus of claim 21, wherein the analyzer further comprises:
a light source; and
a detector.

24. The apparatus of claim 21, wherein the light source reflects off the polishing fluid disposed on the polishing material.

25. The apparatus of claim 21, wherein the analyzer is a spectrograph.

26. The apparatus of claim 21 further comprising:
a tube that places the analyzer in communication with the polishing fluid.

27. The apparatus of claim 21, wherein the polishing fluid disposed on the polishing material contains polishing by-products that are analyzed.

28. The apparatus of claim 21, wherein the analyzer is a particle measuring device.
